# EUROPEAN PATENT APPLICATION

(11) **EP 2 241 901 A1**
(43) Date of publication of application: **20.10.2010**
(21) Application number: 09157920.1
(22) Date of filing: 15.04.2009
(51) Int. Cl.: G01R 31/08, H05B 3/56

(54) **System and method for determining cable fault locations or areas in an electric haeting cable.**

(71) Applicant: Nederlandse Organisatie voor Toegepast -Natuurwetenschappelijk Onderzoek TNO, 2628 VK Delft (NL)
(72) Inventor: Nieuwkoop, Evert, 2641 MK Pijnacker (NL); Mulckhuyse, Wouter Frans Willem, 1403 SV Bussum (NL); Vogel, Teunis, 2582 LH Den Haag (NL)
(74) Representative: Hatzmann, Martin

(57) **Abstract**

Method for determining cable faults in an electric heating cable comprising at least two well conductive lines having an electrical resistor material in between them and electrically connected to the conductive lines in order to dissipate power over mainly the whole length of the cable when connected to an electric power source. Such cable fault may be caused by electrical disconnection between the resistor material and the conductive lines, resulting in interruption of the power dissipation there. The method comprises the steps of
a. sending an electrical signal having a predetermined electric power P_{A}, from a location A to a location B of the cable and determining the power P_{A} of the signal arrived at location B,
b. sending an electrical signal having the predetermined electric power P_{A}, from location A at a moment T₁, as well as sending an opposite electrical signal having a predetermined electric power P_{B} from location B at a moment T_{B} which is chosen such that the first signal and the opposite signal meet each other at a predetermined location C between the locations A and B, and determining the power P_{A}" of the signal arrived at location B,
c. comparing the power P_{A}" of the signal arrived at location B determined in step b. with the power P_{A}' of the signal arrived at location B determined in step a. and concluding either that if P_{A}" is lower than P_{A}', location C is not faulty, or if P_{A}" is not lower than P_{A}', location C is faulty.

## Description

The present invention concerns a method for determining one or more cable fault locations or areas in an electric heating cable comprising at least two well conductive lines having an electrical resistor material in between them and electrically connected to the conductive lines in order to produce heat over mainly the whole length of the cable when connected to an electric power source.

Such heating cables are generally known. The cables may be used to keep e.g. pipes, valves, tanks etc. in chemical plants, fluid distribution systems etc. at a desired (minimum) temperature, e.g. in order to secure that fluids flowing through those pipes, valves etc. remain liquid, in order words, that those fluids will not coagulate or freeze due to too low temperature. For that reason the heating cables are wound around or otherwise connected with the relevant pipes etc. For the sake of heat isolation, the pipes etc. (including their heating cables) will normally be surrounded by an isolation layer of e.g. rock or glass wool, which layer can be covered by e.g. an aluminium shielding.

The heating cable normally comprises two or more well conductive lines having an electrical resistor material in between them and electrically connected to the conductive lines in order to dissipate power over mainly the whole length of the cable when connected to an electric power source. In practice, however, faults may occur in the heating cables when, at certaat locations or areas, the electrical resistor material in between the conductive lines loose their (electrical) contact with the conductive lines. Due to this the heating cable will not dissipate any power in those faulty locations or areas as no electrical current is able to flow through the resistor material in those locations or areas where the electrical connection is interrupted.

Due to the fact that the heating cables normally will be covered by isolation material, fault locations cannot be detected from the outside of the isolated pipes, valves etc., causing that faulty (i.e. not heated) locations and areas cannot be detected. Moreover, when it appears that e.g. the throughput of a pipe section decreases, which could be blamed on malfunctioning of the relevant heating cable, until now no useful methods exist to determine -without dismantling the relevant pipe section's isolation and cover layer- at which location(s) the heating cable is faulty, so that the isolation layer and cover has to be removed over the whole pipe section.

One aspect of the present invention is to provide a novel method for determining one or more cable fault locations or areas in an electric heating cable.

Another aspect of the present invention is to provide such method which is not based on signal reflection time measurement, known as such, but which kind of measurement is not appropriate as, due to the significant cable resistance -inherent to heating cables- (reflection) signals will extinguish very rapidly, causing that no well recognizable reflection signal can be detected.

Moreover, it is found that in practice more reflections signals (all being extremely weak) occur, causing that fault locations in the heating cable cannot be determined with any serious certainty. Besides, reflection time measurements only would be able to give an indication of variations in the impedance of the cable, i.e. would only indicate the begin and the end location of a faulty cable area. Therefore it is still another aspect of the invention to provide a method which determines all individual locations at which the resistor material between the conductive "power feeding lines" of the heating cable has become disconnected from one or both power feeding lines, causing an interruption of the power dissipation in those faulty locations or areas.

According to the present invention it is preferred to perform the following steps (steps a. and b. to be performed in any order):
a. sending an electrical signal having a predetermined electric power P_{X}, from a location X to a location Y of the cable and determining the power P_{X}' of the signal arrived at location Y;
b. sending an electrical signal having said predetermined electric power P_{X}, from location X at a moment T_{X}, as well as sending an opposite electrical signal having a predetermined electric power P_{Y} from location Y at a moment T_{Y} which is chosen such that the first signal and the opposite signal meet each other at a predetermined location Z between the locations X and Y, and determining the power P_{X}" of the signal arrived at location Y;
c. comparing the power P_{X}" of the signal arrived at location Y determined in step b. with the power Px' of the signal arrived at location Y determined in step a. and concluding either that
   - if the power P_{X}" determined in step b. is lower than the power P_{X}' determined in step a., location Z is not faulty, or
   - if the power P_{X}" determined in step b. is not lower than the power P_{X}', location Z is faulty.

The invention is based on the following:
Suppose that an electric pulse having an electric power P_{X} is sent at a moment T_{X} from one end X of a "suspicious" section of a heating cable. At each subsequent moment T_{L} the pulse will - provided that the cable is in good order- dissipate power at cable location L which is proportional with U_{L(X)}² (viz. P_{L(X)} = U_{L(X)}² / R_{L}), in which P_{L(X)} is the electric power at location L caused by the pulse P_{X} launched at location X, U_{L(X)} is the electric voltage over the feeding lines caused by pulse P_{X} and R_{L} is the electric resistance between the feeding lines at location L).

Suppose, furthermore, that another pulse, hereinafter called "opposite" pulse or signal, is sent from the opposite end Y of the cable section at the same moment (T_{Y}= T_{X}), the opposite electrical signal having an electric power P_{Y} which is equal to the power P_{X} of the first pulse. At each subsequent moment the pulse -running in the direction opposite to the running direction of the first pulse- will likewise dissipate a power which is proportional with U_{L(Y)}² (which is equal to U_{L(X)}² as P_{Y} is equal to P_{X}).

As both pulses are sent at the same moment T_{X} = T_{Y} from the opposite cable ends, they will meet in the middle of the cable section and fortify each other such that the power dissipation in that meeting point Z will rise fourfold, viz. because both voltages, U_{Z(X)} (i.e. the voltage in Z caused by the pulse launched in X) and U_{Z(Y)} (i.e. the voltage in Z caused by the pulse launched in Y) will be added one another, causing that U_{Z} = U_{Z(X)} + U_{Z(Y)} = 2 * U_{Z(X)} (= 2 * U_{Z(Y)}) and thus P_{Z} = (2 * U_{Z(X)})² / R_{Z} = 4 _{*} U_{Z(X)}² / R_{Z} = 4 * P_{Z(X)}. As this power is dissipated by two pulses (viz. the first pulse and the opposite pulse), at the meeting location Z the power dissipation per pulse (assigned to each pulse) is twice compared with the power dissipation at all other locations of the cable.

As will further be elucidated graphically hereinafter, the meeting (or crossing) of both pulses, sent from end X and end Y respectively, thus will cause extra power dissipation at meeting location Z. This extra power dissipation thus will cause a dip in the power course of the pulse, travelling further from point Z towards its end point Y, which dip can be detected at the other side Y of the cable, viz. by comparing the power P_{X}" (i.e. the remaining power of the pulse sent from location X) measured at location Y, with the power P_{X}' measured at location Y when no (opposite) electric pulse would be transmitted from location Y towards location X (thus causing no voltage doubling at any meeting point between X and Y).

So, when Z is a location in which the heating cable functions faultless (i.e. the resistor material is well connected to the feeding lines), a relative power dip of the pulse sent from location X can be detected at location Y, which power dip can be measured by measuring the power P_{X}" of the remaining pulse at location Y and comparing it with a previously (or afterwards) determined level P_{X}' of the remaining pulse at location Y when no opposite pulse was launched from location Y.

When, however, Z would be a location in which the heating cable functions faulty (i.e. the resistor material is disconnected from the feeding lines), no power dip of the pulse sent from location X will be detected at location Y (i.e. the power P_{X}" of the remaining pulse at location Y will be equal to or even higher than the previously or afterwards determined level P_{X}'. The reason is that, although the summed voltage in the (now faulty) meeting location of both pulses, originated from locations X and Y respectively, is twice the voltage caused by each individual pulse, however, no extra power dissipation will occur -which would cause a power dip- as, since the resistor material is disconnected from the feeding lines at location Z, the electrical current will not be able to flow through the resistor material there and thus no power dissipation will occur at location Z at all, due to which the pulse power will not decrease at all at location Z (and in every faulty location or area). So, instead of causing a power dip, the power level of the pulse(s) travelling through a faulty location or area will remain constant. As a result of this at the "upstream" end Y (upstream for the pulse originated at location X) it can be measured that the power level P_{X}" of the pulse received from location X is not lower than the previously (or afterwards) measured level P_{X}' without an opposite pulse travelling from Y towards X.

In this way it can be detected whether the location Z is faulty or faultless. It will be understood that the location Z of the meeting point of the mutual opposite pulses can be varied by varying the moments T_{X} and T_{Y} at which the mutually opposite pulse are "launched" at the cable ends X and Y towards their opposite ends Y and X respectively, or rather by varying the time difference between T_{X} and T_{Y}, i.e. their period p_{X-Y}, from -t_{XY} to +t_{XY} -where t_{XY} is the electrical transit time for a signal to travel from X to Y or *vice versa-* the location Z of the meeting point of the oppositely travelling pulses can be set and, by doing so, all locations Z between X and Y can be checked for a fault in the connection of the resistor material with the feeding lines.

In each of such measurement of the local cable condition, at subsequently varying pulse meeting locations Z, it may thus either be concluded that, if the power P_{X}" is lower than the power P_{X}', the investigated location Z is not faulty, or reversely, it may be concluded that that if the power P_{X}" is not lower (i.e. equal or higher) than the (previously or subsequently measured) power P_{X}', location Z is faulty. By e.g. plotting or any other graphical display of the results for the varying locations Z from location X to location Y, a reliable image can be made of the condition of the complete cable section X-Y, which enables to determine the fault locations or areas of the heating cable attached to the relevant e.g. pipe section to be heated, after which only the pipe isolation layer needs to be removed in order to replace the faulty heating cable part by a new, faultless cable part, thus preventing, as aimed by the present invention, to be forced to remove the pipe isolation over a considerably larger area.

As said before, it is preferred that the method steps are repeated using different values for the period p_{X-Y} between T_{X} and T_{Y} ranging from -t_{XY} to +t_{XY} (t_{XY} being the signal running time ). Furthermore, it is preferred to register and/or display, for the relevant values of the period p_{X-Y} and the resulting values of the meeting location Z, for which values of Z location Z is deemed to be faulty and for which values of Z location Z is deemed to be not faulty.

Preferably, the powers P_{X} and P_{Y} are chosen so that the power P_{Z(X)} at location Z caused by the signal sent from location X and the power P_{Z(Y)} at location Z caused by the signal sent from location Y have substantially the same order of magnitude. This will cause that the sum of the voltages of the meeting (or crossing) pulses in the meeting location Z always has about the double value of the voltage cause by one single pulse, which will give an optimal dip value in the course of further travelling pulse(s). To enable this preference, the powers of both opposite pulses, sent from X and Y respectively, are preferably chosen equal one another, but if the meeting location Z is set -by choosing appropriate pulse transmission moments T_{X} and Ty- e.g. is chosen more towards the location of X, the power P_{Y} of the pulse transmitted from location Y has to be chosen accordingly larger than the power P_{X} of the pulse transmitted from location X, as the pulse from Y will experience, due to the relative larger distance from Y to Z than from X to Z, more damping (mainly due to the resistor material between the feeding lines) of the "opposite" pulse sent from location Y. Reversely, if location Z -set by the difference of T_{X} and T_{Y} (i.e. the absolute value of p_{X-Y)}- is more towards location Y, the power P_{X} of the pulse transmitted from location X has preferably to be set accordingly larger than the power P_{Y} of the pulse transmitted from location Y.

If meeting location Z is more close to location Y than to location X, P_{X} has to be larger than P_{Y} in order to obtain the preferred situation that pulse P_{Z(X)} has approximately the same power as pulse P_{Z(Y)}. In that case also P_{X}' will be larger than P_{Y}'. On the other hand, if location Z is more close to X than to Y, P_{Y}' has to be larger than P_{X}'. Therefore in the latter case it is preferred in steps a. to c. to consider location X as being location Y and vice versa (in other words to exchange locations X and Y. This will make that when meeting location Z is closer to location Y than to X, the (detected) signal levels of P_{X}' and P_{X}" are rather large (compared with the signal levels of P_{Y}' and P_{Y}"), which will lead to a decrease of the measurement uncertainty.

To counteract any pulse distortion caused by the heating cable's signal transmission characteristics), which would cause both opposite pulses to appear at their meeting location Z having a rather indefinite shape -which might make the findings about the location Z less certain-, it may be preferred that the signals sent from locations X and Y respectively are formed -e.g. processed in their frequency domain or using any other method well known as such in the art of signal transmission- such that both signals have a well defined and definite pulse shape at their meeting location Z.

The present invention includes any system arranged for performing the novel method according to the invention as presented in the preceding.

The invention now will be elucidated by reference of some illustrative figures. Location X, mentioned in the preceding, may correspond either to location A or to location B in the following figures. In the same way location Y, mentioned in the preceding, may correspond either to location B or to location A respectively. Both locations A and B may be considered equivalent. Location Z, mentioned in the preceding will be called location C in the following figures.
- Figure 1: shows a diagram illustrating the power of one pulse travelling between two locations A and B of a faultless heating cable;
- Figure 2: shows a diagram illustrating the powers of two opposite pulses travelling along a faultless cable from locations A to B and from locations B to A respectively and meeting in a meeting location C in between locations A and B;
- Figure 3: shows a diagram illustrating the powers of two opposite pulses travelling along a faultless cable from locations A to B and from locations B to A respectively and meeting in a meeting location C more towards location B.
- Figure 4: shows a diagram illustrating the power of one pulse travelling along two locations A and B of a faulty heating cable;
- Figure 5: shows a diagram illustrating the powers of two opposite pulses travelling along a faulty cable from locations A to B and from locations B to A respectively and meeting in a meeting location C in between locations A and B;

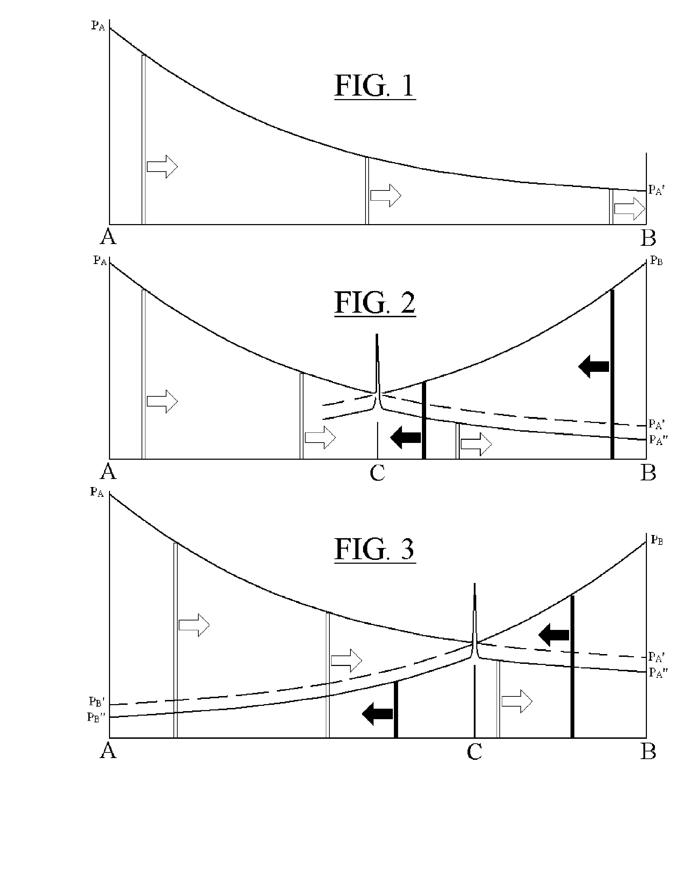

Figure 1 shows a diagram illustrating one pulse travelling through a (faultless) heating cable from one cable location (or cable end) A and launched at a moment T_{A} to another one B, where it arrives at a moment T'₁. The period between T_{A} and T'₁ is equal to the electrical transit time t_{AB} between A and B. The value of the power of the pulse at location A is P_{A}, which power decreases -due to the cable's loss, substantially caused by the resistor material between the cable's well conductive feeding lines- to a value P_{A}' on arrival at location B.

Figure 2 shows a diagram illustrating two opposite pulses travelling from A to B (indicated as white pulse) and, oppositely, from B to A ((indicated as black pulse) respectively and meeting in a meeting location C in the middle between A and B. As both pulses are sent at the same moment T_{A} from the opposite cable ends, they will meet in the middle of the cable section and fortify each other such that the power dissipation in that meeting point C will rise fourfold, viz. because both voltages, U_{C(A)} (i.e. the voltage in C caused by the pulse launched in A) and U_{C(B)} (i.e. the voltage in C caused by the pulse launched in B) will be added one another, causing that U_{C} = U_{C(A)} + U_{C(B)} = 2 * U_{C(A)} (= 2 * U_{C(B)}) and thus P_{C} = (2 * U_{C(A)})² / R_{C} = 4 * U_{C(A)}² / R_{X} = 4 * P_{C(A)}. As this power is dissipated by two pulses (viz. the first pulse and the opposite pulse), at the meeting location C the power dissipation per pulse is twice compared with the power dissipation at all other locations of the cable. As is illustrated in figure 2, the meeting (or crossing) of both pulses in point C, causing extra power dissipation there, will cause, after an initial power doubling, a power fall, which results in a dip in course of the power of the pulse, travelling further from point C towards its end point B, which dip can be detected at the other side B of the cable, viz. by comparing the power P_{A}" (i.e. the remaining power of the pulse sent from location A) measured at location B (at moment T'₁, i.e. the pulse launching moment T_{A} plus the transit time t_{AB} of an electrical pulse from A to B), with the power P_{A}' (indicated as a dashed line) measured without an (opposite) electric pulse transmitted from location B towards location A (and thus without causing voltage doubling at any meeting point between A and B).

So, when C is a location in which the heating cable functions faultless (i.e. the resistor material is well connected to the feeding lines), a relative power dip of the pulse sent from location A can be detected at location B, which power dip can be measured by measuring the power (P_{A}') of the remaining pulse at location B and comparing it with a previously or afterwards determined level (P_{A}').

Figure 3 is similar to figure 2 but differs from it by the location C which is to be investigated by sending pulses from both sides -i.e. the locations A and B- to it. Figure 3 illustrates that when the distance A - C (location C is determined by the mutual difference in the pulse launching moments T_{A} and T_{B}) is larger than C - B the starting power P_{A} of the pulse which is launched from location A, needs to be larger than the starting power P_{B} of the pulse which is launched from location B, as it will be preferred that both mutually opposite pulses have about the same power value during their meeting/crossing moment C. For the rest the effects, illustrated in figure 3 are equal to those shown in figure 2. In figure 3 the complete course of the pulse sent from B to A has been drawn: it can be seen that the powers of both pulses will be affected by their mutual crossing in meeting location C, causing that their respective pulse voltages are added to (about) the double voltage, causing a fourfold power dissipation, which, however, is assigned to both pulses: each pulse thus experiences about a twofold power dissipation during the pulse crossing, as a result of which the power course of both pulses will be experience a dip, which can be seen in figure 3.

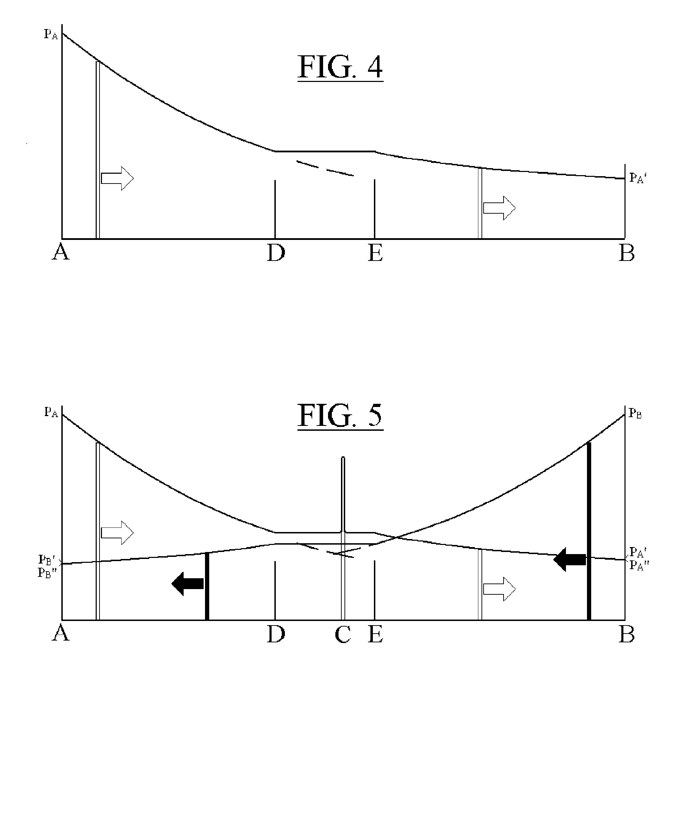

Figures 4 and 5 illustrate the effect of a faulty cable area between locations D and E on pulses sent from the locations A and B respectively.

In figure 4 a pulse is sent from location A to location B, travelling along faultless areas A - D and E - B, as well as along the faulty cable area D - E. Due to the resistance between the feeding lines caused by the resistor material connected to both feeding lines, the pulse power will start with value P_{A} and will decrease regularly until location D. As the cable area between locations D and E are faulty, i.e. the resistance material is disconnected there from one or both feeding lines, no electric current will flow through the resistor material in that area D - E when the (feeding) pulse travels along that area D - E and thus no power (power) dissipation will occur there. For that reason the pulse power will not (or hardly) decrease: the power course will be rather constant instead of decreasing as is the case when the cable area D - E would be faultless (see e.g. figure 1). Due to this effect the remaining power P_{A}' at location B will be higher now than when the area D - E would have been faultless (compare the level of P_{A}' here with the level of P_{A}' in figure 1).

Figure 5 illustrates sending of one pulse from A to B and another pulse, oppositely, from B to A; both pulses are launched at about the same moment T₁, causing the both pulses will meet one another ("cross") about in the middle between A and B, at meeting location C. If, as was the case in the example illustrated in figure 2, the cable would be faultless at location D, extra power dissipation would occur there due to doubling of the pulse voltage and thus doubling of the power dissipation of each individual pulse, resulting in lower values for P_{A}" and P_{B}" (which would have been P_{A}' and P_{B}' without the "pulse crossing effect"). However, as in this example, illustrated in figure 5, location C is inside the faulty area D - E, despite the doubling of the pulse voltage in meeting location C, as there is no power dissipation at all (due to the disconnection of the resistor material from its feeding lines), there will also be no extra power dissipation at location C and for that reason no power dip (as seen in e.g. figure 2) will occur at all. So the remaining power P_{A}" will have the same level as the power P_{A}' shown in figure 4.

In this way it can be detected whether the location C is faulty or faultless. It may be clearly understood that the location C of the meeting point of the mutual opposite pulses can be varied by varying the moments T_{A} and T_{B} at which the opposite pulses are "launched" at the cable ends A and B towards their opposite ends B and A respectively, or rather by varying the time difference between T_{A} and T_{B} (i.e. their period p₁₋₂) within the electrical transit time t_{AB} for a pulse to travel from A to B or *vice versa.* So, by varying p₁₋₂ from -t_{AB} to +t_{AB} the location C of the meeting point of the oppositely travelling pulses can be set and, by doing so, all locations C between A and B can be checked for a fault in the connection of the resistor material with the feeding lines.

In each of such measurement of the local cable condition, at subsequently varying pulse meeting locations C, it may thus either be concluded that, if the power P_{A}" is lower than the power P_{A}', the investigated location C is not faulty, or reversely, it may be concluded that that if the power P_{A}" is equal or even (see figures 4 and 5) higher than the power P_{A}', location C is faulty.

By e.g. plotting or any other graphical display of the results for the varying locations C from location A to location B, a reliable image can be made of the condition of the complete cable section A-B, which enables to determine the fault locations or areas of the heating cable attached to the relevant e.g. pipe section to be heated, after which only the pipe isolation layer needs to be removed in order to replace the faulty heating cable part by a new, faultless cable part, thus preventing, as aimed by the present invention, to be forced to remove the pipe isolation over a considerably larger area.

Depending on the location of meeting C, i.e. more towards location B or more towards location A, it may be preferred either to launch, in steps a. and b. a signal from A to B and (in step b.) an opposite signal from B to A (as illustrated in the figures), or to launch, in steps a. and b. a signal from B to A and (in step b.) an opposite signal from A to B (not illustrated in the figures):
I. If the signal meeting point C is located more towards location B (e.g. in figure 3) it may be preferred to compare the values of P_{A}' and P_{A}", both originated by a signal P_{A} launched in A, which signal P_{A} preferably will be chosen larger than P_{B} in order to achieve signal magnitudes P_{C(A)} and P_{C(B)} in meeting point C which are about equal, due to which also the values of P_{A}' (step a.) and P_{A}" (step b.) will be rather large and thus better detectable. In that case the process steps are (X = A, Y = B, Z = C):
   a. sending an electrical signal having a predetermined electric power P_{A}, from a location A to a location B of the cable and determining the power P_{A}' of the signal arrived at location B;
   b. sending an electrical signal having said predetermined electric power P_{A}, from location A at a moment T_{A}, as well as sending an opposite electrical signal having a predetermined electric power P_{B} from location B at a moment T_{B} which is chosen such that the first signal and the opposite signal meet each other at a predetermined location C between the locations A and B, and determining the power P_{A}" of the signal arrived at location B;
   c. comparing the power P_{A}" of the signal arrived at location B determined in step b. with the power P_{A}' of the signal arrived at location B determined in step a. and concluding either that
      - if the power P_{A}" determined in step b. is lower than the power P_{A}' determined in step a., location C is not faulty, or
      - if the power P_{A}" determined in step b. is not lower than the power P_{A}', location C is faulty.
II. If, however, the signal meeting point C is located more towards location A it may be preferred to compare the values of P_{B}' and P_{B}", both originated by a signal P_{B} launched in B, which signal P_{B} preferably will be chosen larger than P_{A} in order to achieve signal magnitudes P_{C(A)} and P_{C(B)} in meeting point C which are about equal, due to which also the values of P_{B}' (step a.) and P_{B}" (step b.) will be rather large and thus better detectable. In that case the process steps are (X = B, Y = A, Z = C):
   a. sending an electrical signal having a predetermined electric power P_{B}, from a location B to a location A of the cable and determining the power P_{B}' of the signal arrived at location A;
   b. sending an electrical signal having said predetermined electric power P_{B}, from location B at a moment T_{B}, as well as sending an opposite electrical signal having a predetermined electric power P_{A} from location A at a moment T_{A} which is chosen such that the first signal and the opposite signal meet each other at a predetermined location C between the locations B and A, and determining the power P_{B}" of the signal arrived at location A;
   c. comparing the power P_{B}" of the signal arrived at location A determined in step b. with the power P_{B}' of the signal arrived at location A determined in step a. and concluding either that
      - if the power P_{B}" determined in step b. is lower than the power P_{B}' determined in step a., location C is not faulty, or
      - if the power P_{B}" determined in step b. is not lower than the power P_{B}', location C is faulty.

## Claims

1. Method for determining one or more cable fault locations or areas in an electric heating cable comprising at least two well conductive lines having an electrical resistor material in between them and electrically connected to said conductive lines in order to dissipate power over mainly the whole length of the cable when connected to an electric power source, said cable fault including or caused by electrical disconnection between the resistor material and at least one of said conductive lines in said one or more fault locations or areas, resulting in an interruption of the power dissipation in said locations or areas, the method comprising the following steps, steps a. and b. in any order:
a. sending an electrical signal having a predetermined electric power P_{X}, from a location X (A or B) to a location Y (B or A respectively) of the cable and determining the power P_{X}' of the signal arrived at location Y;
b. sending an electrical signal having said predetermined electric power P_{X}, from location X at a moment T_{X}, as well as sending an opposite electrical signal having a predetermined electric power P_{Y} from location Y at a moment T_{Y} which is chosen such that the first signal and the opposite signal meet each other at a predetermined location Z between the locations X and Y, and determining the power P_{X}" of the signal arrived at location Y;
c. comparing the power P_{X}" of the signal arrived at location Y determined in step b. with the power P_{X}' of the signal arrived at location Y determined in step a. and concluding either that
- if the power P_{X}" determined in step b. is lower than the power P_{X}' determined in step a., location Z is not faulty, or
- if the power P_{X}" determined in step b. is not lower than the power P_{X}', location Z is faulty.

2. Method according to any preceding claim, where the electrical transit time t_{XY} for either electrical signal to travel from X to Y or *vice versa* and where said steps are repeated using different values for the period P_{X-Y} between T_{X} and T_{Y} ranging from -t_{XY} to +t_{XY}.

3. Method according to claim 2, where for the relevant values of said period p_{X-Y} and the resulting values of the meeting location Z it is registered for which values of Z location Z is faulty and for which values of Z location Z is not faulty.

4. Method according to any preceding claim, where the powers P_{X} and P_{Y} are chosen so that the power P_{Z(X)} at location Z caused by the signal sent from location X and the power P_{Z(Y)} at location Z caused by the signal sent from location Y have substantially the same order of magnitude.

5. Method according to claim 4, wherein, when the meeting location Z (C) is more close to location Y (B, A) than to location X (A, B), the power P_{X} of the signal sent from location X both in step a. and in step b. is chosen larger than the power P_{Y} of the signal sent from location Y in step b., and wherein the power P_{X}" of the signal arrived at location Y determined in step b. is compared with the power P_{X}' of the signal arrived at location Y determined in step a.

6. Method according to claim 4, wherein, when the meeting location Z (C) is more close to location X (A, B) than to location Y (B, A), the power P_{Y} of the signal sent from location Y both in step a. and in step b. is chosen larger than the power P_{X} of the signal sent from location X in step b., and wherein the power P_{Y}" of the signal arrived at location X determined in step b. is compared with the power P_{Y}' of the signal arrived at location X determined in step a.

7. Method according to any preceding claim, where the signals sent from locations X and Y respectively are formed such that both signals have a substantial pulse shape at their meeting location Z.

8. Method according to claim 1, where the measurement uncertainty is improved by successively repeating said steps a. to c.

9. System for determining one or more cable fault locations or areas in an electric heating cable comprising at least two well conductive lines having an electrical resistor material in between them and electrically connected to said conductive lines in order to dissipate power over mainly the whole length of the cable when connected to an electric power source, said cable fault including or caused by electrical disconnection between the resistor material and at least one of said conductive lines in said one or more fault locations or areas, resulting in an interruption of the power dissipation in said locations or areas, the system being arranged for performing the method according to any preceding claim.
